# EUROPEAN PATENT APPLICATION

(11) **EP 2 053 642 A1**
(43) Date of publication of application: **29.04.2009**
(21) Application number: 07791665.8
(22) Date of filing: 31.07.2007
(51) Int. Cl.: H01L 21/316

(54) **FILM-FORMING METHOD AND FILM-FORMING APPARATUS**

(30) Priority: 02.08.2006 JP 2006211090
(71) Applicant: Ulvac, Inc., Chigasaki-shi, Kanagawa 253-8543 (JP)
(72) Inventor: MASUDA, Takeshi, Susono-shi, Shizuoka 410-1231 (JP); KAJINUMA, Masahiko, Susono-shi, Shizuoka 410-1231 (JP); NISHIOKA, Yutaka, Susono-shi, Shizuoka 410-1231 (JP); KIMURA, Isao, Susono-shi, Shizuoka 410-1231 (JP); KIKUCHI, Shin, Susono-shi, Shizuoka 410-1231 (JP); YAMADA, Takakazu, Susono-shi, Shizuoka 410-1231 (JP); SUU, Koukou, Susono-shi, Shizuoka 410-1231 (JP)
(74) Representative: Eisenführ, Speiser & Partner
(86) International application number: PCT/JP2007/064980
(87) International publication number: WO 2008/016044

(57) **Abstract**

A film forming method in which a crystalline film having PZT (111) as a principal component thereof is laminated on a foundation film having a (111) oriented noble metal as a principal component thereof, the method including the steps of: forming an oxide film whose interplanar spacing is closer to the PZT (111) than to the noble metal, on a surface of the foundation film; and forming the crystalline film on the surface of the foundation film by an MOCVD method.

## Description

### TECHNICAL FIELD

The present invention relates to a film forming method and film forming apparatus.
Priority is claimed on Japanese Patent Application No. 2006-211090, filed August 2, 2006, the contents of which are incorporated herein by reference.

### BACKGROUND ART OF THE INVENTION

Among lead zirconate titanates (Pb (Zr, Ti) O₃; PZT) having a Perovskite structure, those having a (111) orientation are used as a ferroelectric film to create ferroelectric memory due to the fact that they show stable polarization at low voltages. The use of a metal-organic chemical vapor deposition (MOCVD) process, which has superior step coverage, is also being examined as a process for manufacturing a ferroelectric film consisting of the (111) orientation PZT (referred to below as PZT (111)). In CVD methods in which a film is formed on a substrate by reacting a thin film raw material at a high temperature, the MOCVD method particularly employs an organometal for the raw material, in which a film is formed by reacting an organometallic gas and an oxide gas.

Technology in which Ir (111) whose interplanar spacing is close to that of PZT (111) is used for a lower electrode film (i.e., a foundation film) has been proposed as a process to form PZT (111) by employing an MOCVD method.
However, even if PZT is formed on a surface of Ir (111), the preferred orientation is not obtained for PZT (111), and there ends up being a random orientation which includes PZT (110), PZT (100), and the like

Therefore, technology has been proposed in Patent document 1 in which, firstly, an initial layer having a (111) orientation is formed at a low oxygen concentration, and ferroelectric films are then continuously accumulated thereon at a higher oxygen concentration. Accordingly, with the initial layer being a nucleus, the entire ferroelectric film is given a (111) orientation. Moreover, technology has been proposed in Patent document 2 in which, by forming a titanium nucleus on an iridium lower electrode prior to the forming of the PZT film, a PZT film having superior denseness is formed centered on the titanium nucleus.
Patent document 1: Japanese Unexamined Patent Application, First Publication No. 2003-324101
Patent document 2: Japanese Unexamined Patent Application, First Publication No. 2005-150756

### DETAILED DESCRIPTION OF THE INVENTION

### Problems to be solved by the invention

However, in these technologies, the orientation intensity (degree of orientation) of the PZT (111) is still inadequate, and further enhancement of the orientation intensity of the PZT (111) is desired.
The present invention was conceived in order to solve the above described problems, and it is an object thereof to provide a film forming method and film forming apparatus that make it possible to increase the orientation intensity of the PZT (111).

### Means for solving the problem

In order to achieve the above described object, the present invention employs the following. Namely, the film forming method of the present invention is a film forming method in which a crystalline film having PZT (111) as a principal component thereof is laminated on a foundation film having a (111) oriented noble metal as a principal component thereof, the method including the steps of: forming an oxide film whose interplanar spacing is closer to the PZT (111) than to the noble metal, on a surface of the foundation film; and forming the crystalline film on the surface of the foundation film by an MOCVD method.
According to the above described film forming method, since it is easy for the PZT (111) to grow due to it being assisted by the oxide film formed on the surface of the foundation film, it is possible to increase the orientation intensity of the PZT (111).

It may be arranged such that in the step of forming the oxide film, the oxide film of the noble metal which has a (200) orientation is formed by oxidizing the surface of the foundation film.
In this case, since the oxide film of the (200) oriented noble metal has an interplanar spacing which is closer to the PZT (111) than to the noble metal, it is possible to increase the orientation intensity of the PZT (111). In addition, such type of oxide film of the noble metal can be formed easily.

It may be arranged such that the surface of the foundation film is oxidized using oxidizing gas which is supplied for the MOCVD method.
Furthermore, It may be arranged such that the oxidizing gas is any one or any mixture of oxygen gas, dinitrogen monoxide gas, and ozone gas.
In these cases, since it is not necessary to introduce another oxide gas, it is possible to lower manufacturing costs.

It may be arranged such that in the step of forming the oxide film, the oxide film is formed by being laminated onto the surface of the foundation film.
Furthermore, It may be arranged such that the oxide film has IrO₂ (200) as a principal component thereof.
Furthermore, It may be arranged such that the oxide film has PZT (111) as a principal component thereof.
In these cases, it is possible to increase the orientation intensity of the PZT (111) through the assistance of the oxide film.

It may be arranged such that the oxide film has a crystal-oriented oxide electrode film as a principal component thereof.
Furthermore, It may be arranged such that the oxide electrode film has either SrRuO₃ or LaNiO₃ as a principal component thereof.
In these cases, since SrRuO₃ and LaNiO₃ both have an interplanar spacing which is closer to the PZT (111) than to the noble metal, it is possible to increase the orientation intensity of the PZT (111).

It may be arranged such that the oxide electrode film is formed so as to have a thickness of 3 nm or more.
In this case, it is possible to sufficiently increase the orientation intensity of the PZT (111).
Moreover, It may be arranged such that the oxide electrode film is formed so as to have a thickness of 10 nm or more.
In this case, it is possible to increase the orientation intensity of the PZT (111) even further.

On the other hand, the film forming apparatus of the present invention is a film forming apparatus which forms a crystalline film having PZT (111) as a principal component thereof on a substrate on which a foundation film having a (111) oriented noble metal as a principal component thereof has been formed, the apparatus including: an oxidation chamber in which an oxide film of the noble metal is formed by oxidizing the surface of the foundation film; a film formation chamber in which the crystalline film is formed on the surface of the oxide film using an MOCVD method; and a substrate transporting chamber through which the substrate is transported from the oxidation chamber to the film formation chamber.
According to the above described film forming apparatus, at the same time as oxidation processing is being performed in the oxidation chamber, it is possible to perform film formation processing in the film formation chamber on a substrate which has already undergone oxidation processing, thereby enabling film formation to be performed efficiently. Moreover, since it is possible to transport substrates sequentially to the oxidation chamber and the film formation chamber with the transporting chamber centered, it is possible to improve the manufacturing efficiency. In addition, since the substrate is not exposed to the atmosphere, it is possible to prevent impurities and the like adhering to the substrate.

It may be arranged such that the oxidizing gas which is supplied for the MOCVD process in the film formation chamber is also supplied for the oxidation process performed in the oxidation chamber.
In this case, since it is not necessary to provide another oxidizing gas supply device, it is possible to lower manufacturing costs.

### Advantageous effects of the invention

According to the present invention, since it is easy for the PZT (111) to grow due to it being assisted by the oxide film formed on the surface of the foundation film, it is possible to increase the orientation intensity of the PZT (111).

### BRIEF DESCRIPTION OF THE DRAWINGS

[FIG. 1A] FIG. 1A is a cross-sectional view showing an example of FeRAM.
[FIG. 1B] FIG. 1B is a cross-sectional view showing the detailed structure of a capacitor.
[FIG. 2] FIG. 2 is a schematic structural view of a film forming apparatus.
[FIG. 3] FIG. 3 is a schematic structural view showing a variant example of the film forming apparatus.
[FIG 4A] FIG. 4A is a graph showing an x-ray diffraction (XRD) intensity of a ferroelectric film when the oxygen gas flow time is varied in an oxide film formation step.
[FIG. 4B] FIG. 4B is an enlarged view of an A portion shown in FIG. 4A.
[FIG. 5A] FIG. 5A is a graph showing an x-ray diffraction (XRD) intensity when the surfaces of lower electrode films having different thicknesses from each other are oxidized.
[FIG. 5B] FIG. 5B is an enlarged view of a portion of the vertical axis in FIG. 5A as far as 200 (counts).
[FIG. 6] FIG. 6 is a graph showing a relationship between the orientation intensity of the Ir (111) making up the lower electrode film; and the orientation intensity of the PZT (111) making up the ferroelectric film.

### Description of the reference symbols

- 12: Lower electrode film (foundation film)
- 13: Oxide film
- 15: Ferroelectric film (crystalline film)
- 90: Film forming apparatus
- 92: Film formation chamber
- 93: Substrate transporting chamber
- 94: Oxidation chamber

### BEST MODE FOR CARRYING OUT THE INVENTION

Embodiments of the present invention will now be described with reference to the drawings. Note that the scale of the respective components in the respective drawings used in the description given below has been appropriately modified in order to make the respective components a recognizable size.
The film forming method according to the present embodiment is used to form a ferroelectric film (i.e., a crystalline film) whose principal component is PZT (111), and the ferroelectric film is preferably used in ferroelectric memory (i.e., ferroelectric RAM: FeRAM). For this reason, a description of FeRAM will be given first.

### (FeRAM)

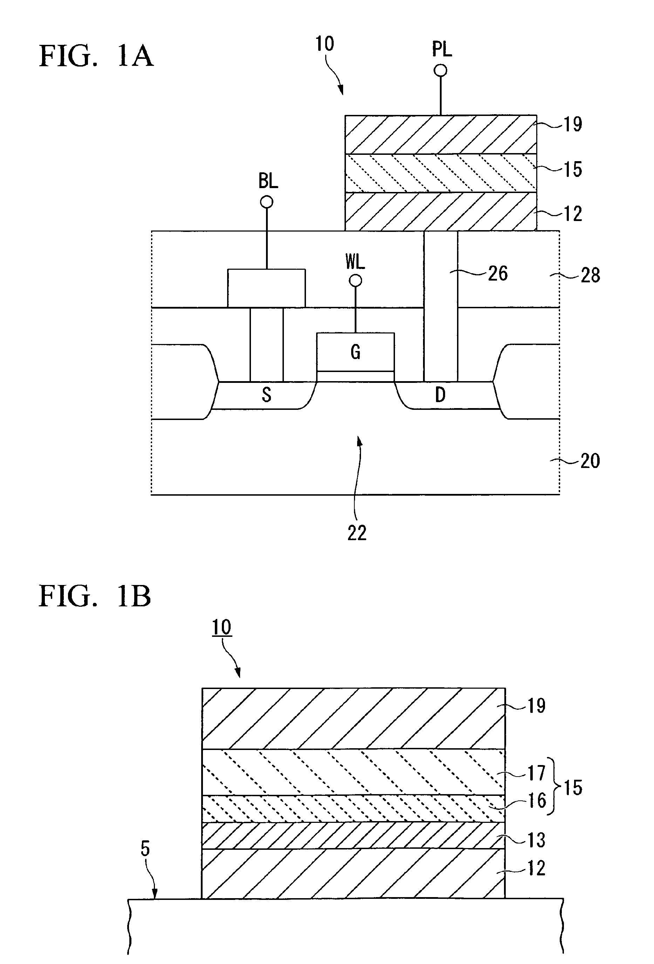

FIG. 1A is a cross-sectional view showing an example of FeRAM. FeRAM is provided with a transistor 22 that is formed on a substrate 20 which consists of silicon or the like, and with a capacitor 10 whose power supply is controlled by the transistor 22. A gate G of the transistor 22 is connected to a word line WL, and a source S thereof is connected to a data line BL.

An interlayer insulating film 28 which is made from an electrically non-conductive material such as SiO₂ or the like is formed so as to cover the transistor 22. A contact 26 which is made from tungsten or the like extends out through the interlayer insulating film 28. The capacitor 10 is formed on a surface of the contact 26 and interlayer insulating film 28. The capacitor 10 is formed such that a ferroelectric film 15 is sandwiched between a lower electrode film (i.e., a foundation film) 12 and an upper electrode film 19. The lower electrode film 12 is connected via the contact 26 to a drain D of the transistor 22. The upper electrode film 19 is connected to a bit lime PL.

The writing of data to the capacitor 10 is performed by turning on the transistor with the word line WL setting to active, and by applying voltage V1I between the data line BL and the bit line PL. For example, if the voltage of the data line BL is set to V₁, and the bit line PL is grounded, then the lower electrode film 12 side of the ferroelectric film 15 is polarized to +, and "1"is written. Conversely, if the data line BL is grounded, and the voltage of the bit line PL is set to V₁, then the upper electrode film 19 side of the ferroelectric film 15 is polarized to +, and "0" is written. Note that the ferroelectric film 15 is used to create non-volatile memory because it is able to hold its polarity state even when the supply of power to the capacitor 10 is stopped.

The reading of data from the capacitor 10 is performed by setting the data line BL in an open state (i.e., high impedance) with the word line WL setting to active, and by applying voltage V₁' to the bit line PL. When the capacitor 10 is holding "0", the polarity is not inverted, and there is substantially no change in the voltage of the data line BL. When the capacitor 10 is holding "1", the polarity is inverted, and a large electric charge flows to the data line BL. Accordingly, it is possible to read either "0" or "1".

FIG. 1B is a cross-sectional view showing the detailed structure of a capacitor. The lower electrode film 12 whose principal component is (111) oriented iridium (referred to as Ir (111)) is formed on a surface of a substrate 5 which is formed in the manner described above. Note that it is also possible for an adhesive layer made from Ti or the like to be formed between the substrate 5 and the lower electrode film 12. In addition, an oxide film 13 which is consists of IrO₂ (200) is formed on a surface of the lower electrode film 12. A ferroelectric film 15 is formed on a surface of the oxide film 13. The ferroelectric film 15 is provided with a bottom layer film 16 and a top layer film 17. The bottom layer film 16 and a top layer film 17 are consists of lead zirconate titanate (Pb (Zr, Ti) O₃; PZT) having a Perovskite structure, especially PZT having a (111) orientation due to its stable polarization characteristics at low voltages. A upper electrode film 19 which consists of Ir (111) or the like is formed on a surface of the ferroelectric film 15.

### (Film forming apparatus)

Next, a description will be given of an apparatus which forms a ferroelectric film making up a capacitor. The ferroelectric film is formed using a metal-organic chemical vapor deposition (MOCVD) method. In CVD methods in which a film is formed on a substrate by reacting a thin film raw material at a high temperature, the MOCVD method particularly employs an organometal for the raw material, in which a film is formed by reacting an organometallic gas and an oxide gas.

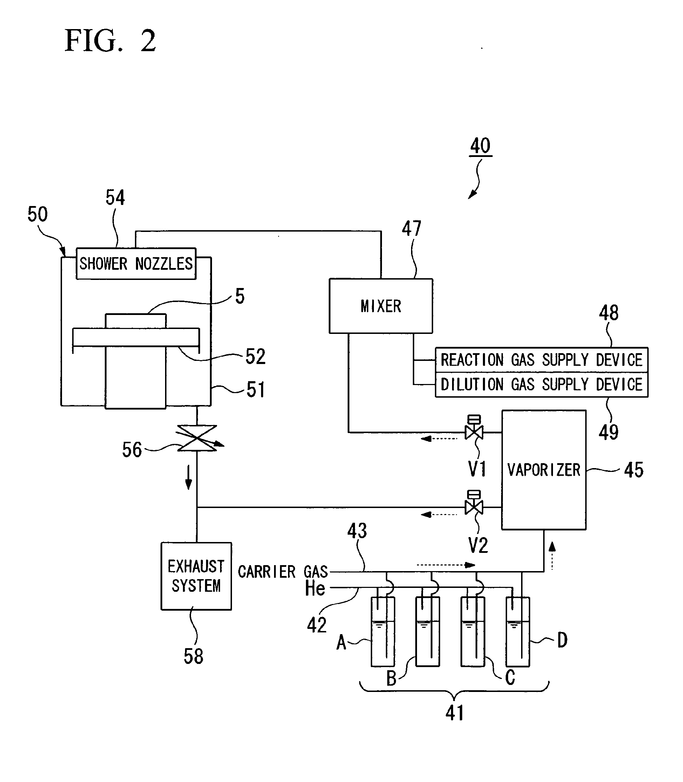

FIG. 2 is a schematic structural view of a film forming apparatus. This film forming apparatus 40 is formed by connecting in the following sequence: a raw material supply unit 41 which supplies an organic solvent solution of an organometal; a vaporizer 45 which creates a raw material gas by vaporizing the solution; a mixer 47 which creates a gas mixture of the raw material gas, a reaction gas, and the like; and a film formation chamber 50 where film formation processing is performed by blowing the gas mixture onto a substrate.

The raw material supply unit 41 is provided with: tanks A, B, C, and D which are filled with organometallic solution and solvent; a supply pipe 42 which supplies He gas to the respective tanks; and a supply pipe 43 for a carrier gas which transports the organometallic solution and solvents discharged from the respective tanks. When He gas is supplied to a tank from the He gas supply pipe 42, the internal pressure of the tank increases, and the organometallic solution and solvent with which the tank has been filled are discharged to the carrier gas supply pipe 43. Droplets of the discharged organometallic solution and solvent are transported to the vaporizer 45 by a carrier gas such as N₂ gas or the like.

The vaporizer 45 vaporizes the droplets of organometallic solution and solvent by heating them, and thereby creates a raw material gas. For this reason, the vaporizer 45 is provided with a heating device (not shown). Note that it is desirable for the vaporization efficiency to be improved by performing the above described process in combination with a process in which gas or ultrasonic waves or the like are made to strike the droplets of the organometallic solution and solvent, or in combination with a process in which droplets which have been atomized in advance via atomization nozzles are introduced.

The mixer 47 creates a gas mixture made up of the created raw material gas and a reaction gas and/or dilution gas. Because of this, a reaction gas supply device 48 and/or a dilution gas supply device 49 are connected to the mixer 47. The reaction gas supply device 48 supplies an oxidizing gas such as oxygen gas, dinitrogen monoxide gas, ozone gas, or the like. The dilution gas supply device 49 supplies nitrogen gas, argon gas, or the like.

The film formation chamber 50 introduces the gas mixture containing the raw material gas, and forms a ferroelectric film on the substrate 5. Shower nozzles 54 which eject the gas mixture towards the substrate 5 are provided in the ceiling of a chamber 51 of the film formation chamber 50. A stage 52 on which the substrate 5 is mounted is provided in the interior of the chamber 51. The stage 52 is provided with a heating device such as a heater or the like (not shown), and is able to heat a substrate 5 which has been mounted thereon. The chamber 51 is connected via a pressure adjustment valve 56 to an exhaust system 58 which is provided with a dry pump or a turbo-molecular pump or the like.

Note that it is also possible to only supply an oxidizing gas, which is a reaction gas, to the film formation chamber 50without supplying a raw material gas thereto. By only supplying an oxidizing gas, it is possible to oxidize the surface of the lower electrode film to form IrO₂ thereon prior to the formation of the ferroelectric film. As a result, in the film formation chamber 50, it is possible to continuously perform the surface refining (i.e., reduction) on the lower electrode and the formation of the ferroelectric film. Moreover, since the same oxidizing gas supply device is used for the oxidation processing and the film formation processing, it is possible to reduce manufacturing costs.

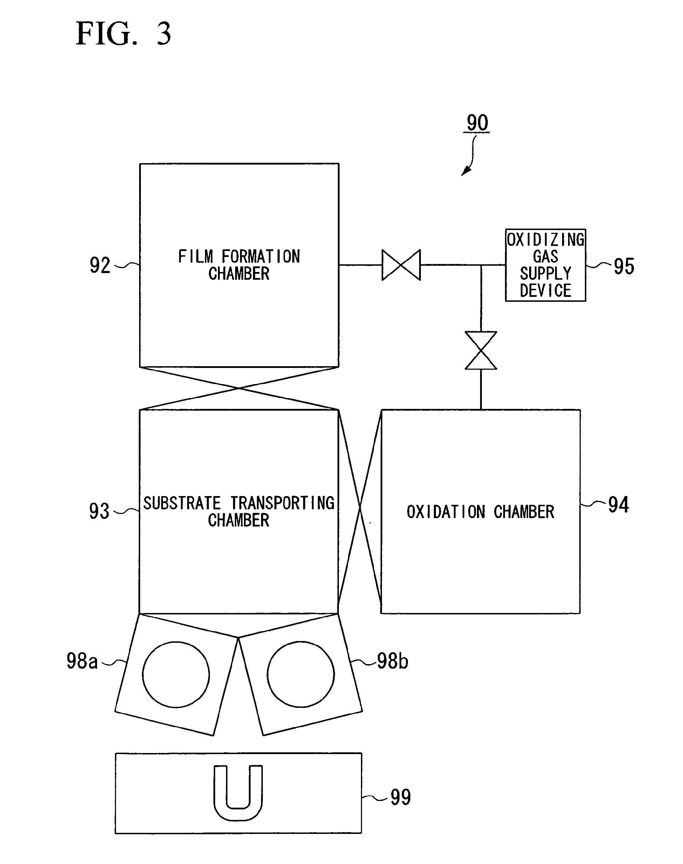

FIG. 3 is a schematic structural view showing a variant example of the film forming apparatus. In a film forming apparatus 90 according to the variant example, an oxidation processing chamber 94 is provided in addition to a film formation chamber 92. The oxidation processing chamber 94 has a function of forming IrO₂ by oxidizing the surface of the lower electrode film prior to the formation of the ferroelectric film thereon. Accordingly, an oxidizing gas supply device 95 is connected to the oxidation processing chamber 94. Because the oxidizing gas supply device 95 can also be used for the film formation chamber 92, manufacturing costs can be reduced. In addition, a heating device (not shown) to heat a substrate is also provided in the oxidation chamber 94.

The oxidation chamber 94 and the film formation chamber 92 are linked to a substrate transporting chamber 93 via gate valves. A substrate transporting robot (not shown) which transports substrates into and away from the oxidation chamber 94 and the film formation chamber 92 is provided in the substrate transporting chamber 93. A plurality of substrate cassettes 98a and 98b are able to be loaded in the substrate transporting chamber 93. By performing processing on a substrate of one of the substrate cassettes and placing the substrates of the other substrate cassette on standby, it is possible to save time and perform processing continuously.

In the film forming apparatus 90, in parallel with the oxidation processing performed in the oxidation chamber 94, it is possible to perform film formation processing in the film formation chamber 92 on substrates which have already undergone the oxidation processing, thereby enabling film formation to be performed efficiently. Moreover, since substrates can be sequentially transported between the substrate cassette 98, the oxidation chamber 94, and the film formation chamber 92 with the transporting chamber 93 centering, it is possible to improve the manufacturing efficiency. At this time, since the substrate is not exposed to the atmosphere, it is possible to prevent impurities and the like adhering to the substrate.

Note that it is also possible for the reduction processing chamber 94 to be provided outside the film forming apparatus 90. In this case as well, in parallel with the oxidation processing performed in the external oxidation chamber 94, it is possible to perform film formation processing in the internal film formation chamber 92 on substrates which have already undergone the oxidation processing, thereby enabling film formation to be performed efficiently.

### (Film forming method)

Next, a film forming method according to a first embodiment of the present invention will be described. The film forming method according to the first embodiment has a step in which the oxide film 13 having IrO₂ (200) as its principal component is formed by oxidizing a surface of the lower electrode film 12 having Ir (111) as its principal component; and a step in which the ferroelectric film 15 having PZT (111) as its principal component is formed by an MOCVD method on the surface of the oxide film 13.

Firstly, as is shown in FIG. 1B, the lower electrode film 12 having Ir (111) as its principal component is formed at a thickness of approximately 70 nm on a surface of the substrate 5. The lower electrode film 12 having Ir (111) as its principal component can be formed, for example, by performing a spattering process or the like while the substrate 5 is being heated to 500°C or more. The lower electrode film 12 having Ir (111) as its principal component can also be formed by performing a spattering process at room temperature so as to create a non-crystalline film of Ir, and by then crystallizing the non-crystalline film by heating it to 500°C or more using a rapid thermal annealing (RTA) apparatus or the like. Note that it is also possible to form a lower electrode film having a noble metal such as (111) oriented Pt or the like as its principal component instead of Ir (111).

Next, the oxide film 13 having IrO₂ (200) as its principal component is formed by oxidizing a surface of the lower electrode film 12. Specifically, a substrate on which the lower electrode film 12 has been formed is mounted on the stage 52 of the film formation chamber 50 shown in FIG. 2. Next, with the valve V1 closed and the supply of raw material gas to the substrate stopped, oxidizing gas is supplied from the reaction gas supply device 48. As a result, oxidizing gas flows for a predetermined time from the shower nozzles 54 of the film formation chamber 50 towards the substrate 5. In this case, the oxidizing gas density inside the chamber 51 may be set, for example, to approximately 90%, and the pressure inside the chamber 51 is set to 5 Torr or more which is the pressure during film formation. Moreover, the substrate 5 is heated to 500°C or more, and preferably to 600°C or more, and more preferably to 620°C or more using the heating device of the stage 52 while the oxidizing gas is flowing.
By performing this process, as is shown in FIG. 1B, the surface of the lower electrode film 12 having Ir (111) as its principal component is oxidized, and the oxide film 13 having IrO₂ (200) as its principal component is formed. In the same way, when a lower electrode film having a (111) oriented noble metal as its principal component is formed, an oxide film of a (200) oriented noble metal is formed.

Next, the ferroelectric film 15 having PZT (111) as its principal component is formed by an MOCVD method on this surface of the oxide film 13. In CVD methods in which a film is formed on a substrate by reacting a thin film raw material at a high temperature, the MOCVD method particularly employs an organometal for the raw material. An organometal whose raw material is PZT includes at least one of Pb, Zr, and Ti, and it is possible to employ Pb (thd)₂ ((bis (2,2,6,6) tetramethyl (3,5) heptanedionate) lead), Zr (dmhd)₄ ((tetrax (2,6) dimethyl (3,5) heptanedionate) zirconium), Ti (iPrO)₂ (thd)₂ ((bis isopropoxide) (bis (2,2,6,6) tetramethyl (3,5) heptanedionate) titanium), and the like. These organometals are dissolved in an organic solvent such as THF (tetrahydrofuran), so as to create an organometallic solution having a concentration of approximately 0.3 mol/L.

The tanks B through D of the raw material supply unit 41 shown in FIG. 2 are filled with the organometallic solution, while only the solvent thereof is placed inside the tank A. Consequently, a raw material gas is created by supplying the organometallic solution and solvent to the vaporizer 45. Next, the raw material gas is supplied to the mixer 47, and a gas mixture is created by mixing the raw material gas with oxygen gas which is an oxide gas (and nitrogen gas which is a dilution gas). The gas mixture is then supplied to the film formation chamber 50, and it is then ejected from the shower nozzles 54 into the interior of the chamber 51.
Note that the supply rate of the raw material gas is adjusted such that the composition of the PZT used to create the bottom layer film 16 and the top layer film 17 which make up the ferroelectric film 15 shown in FIG. 1B satisfies the conditions of Pb / (Zr + Ti) ≒ 1.17 and Zr / (Zr + Ti) ≒ 0.45.

The bottom layer film 16 which makes up the ferroelectric film 15 shown in FIG. 1B is formed so as to have a thickness of approximately 5 nm when the oxygen gas concentration inside the chamber is set to approximately 8.5%. The top layer film 17 which makes up the ferroelectric film 15 is formed so as to have a thickness of approximately 95 nm when the oxygen gas density inside the chamber is set to approximately 85%. If PZT is formed when the oxygen gas concentration is 60% or less, the problem arises of an increase in leakage current in the ferroelectric film which is caused by oxygen deficiency. In contrast, if the oxygen gas concentration is more than 60%, although there is minimal leakage current, there is a decrease in the orientation intensity of the PZT (111). Therefore, by causing the PZT (111) of the top layer film 17 to grow epitaxially using the bottom layer film 16 as a nucleus, it is possible to obtain an improvement in the orientation intensity of the PZT (111) while suppressing leakage current. Note that the supply rate of the raw material gas is adjusted such that the composition of the PZT used to create both the bottom layer film 16 and the top layer film 17 satisfies the conditions of Pb / (Zr + Ti) ≒ 1.17 and Zr / (Zr + Ti) ≒ 0.45.

Consideration will now be given to the relationship between the crystalline structure of the above described lower electrode film 12 and the orientation intensity of the PZT (111) in the ferroelectric film 15.

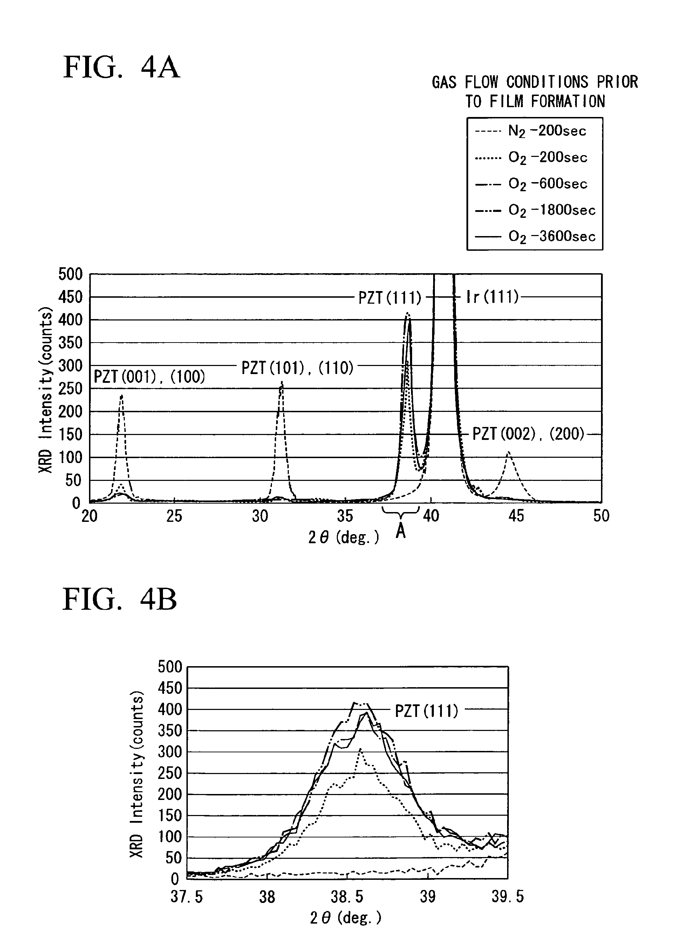

FIG. 4A is a graph showing an X-ray diffraction (XRD) intensity of a ferroelectric film when the flow time of the oxygen gas is varied in the oxide film formation step. TABLE 1 below also shows a relationship between the flow time of the oxygen gas and the film thickness of the oxide film which is formed as a result. As is shown in TABLE 1, as the flow time of the oxygen gas increases, there is a corresponding increase in the thickness of the oxide film which is formed.

**TABLE 1**

| Gas flow conditions prior to film formation | IrO₂ film thickness |
|---|---|
| N₂ - 200 sec | 0.5 nm |
| O₂ - 200 sec | 3 nm |
| O₂ - 600 sec | 5 nm |
| O₂ -1800 sec | 10 nm |

Note that when the flow time was set to 200 seconds using only a dilution gas in the form of nitrogen gas without using an oxidizing gas in the form of oxygen gas, then as is shown in TABLE 1, only a natural oxide film having a thickness of approximately 0.5 nm was formed. In this case, as is shown in FIG. 4, there was substantially no creation of PZT (111), but PZT (101), PZT (110), PZT (001) (100), and the like were created.
In contrast to this, when the oxygen gas was made to flow for more than 200 seconds, as is shown in TABLE 1, IrO₂ (200) having a thickness of 3 nm or more was created. In this case, as is shown in FIG. 4, a considerable quantity of PZT (111) was created, but there was substantially no creation of PZT (101), PZT (110), and PZT (001) (100).

Consideration will now be given as to the reason why the orientation intensity of the PZT (111) increases as a result of the oxide film being formed.

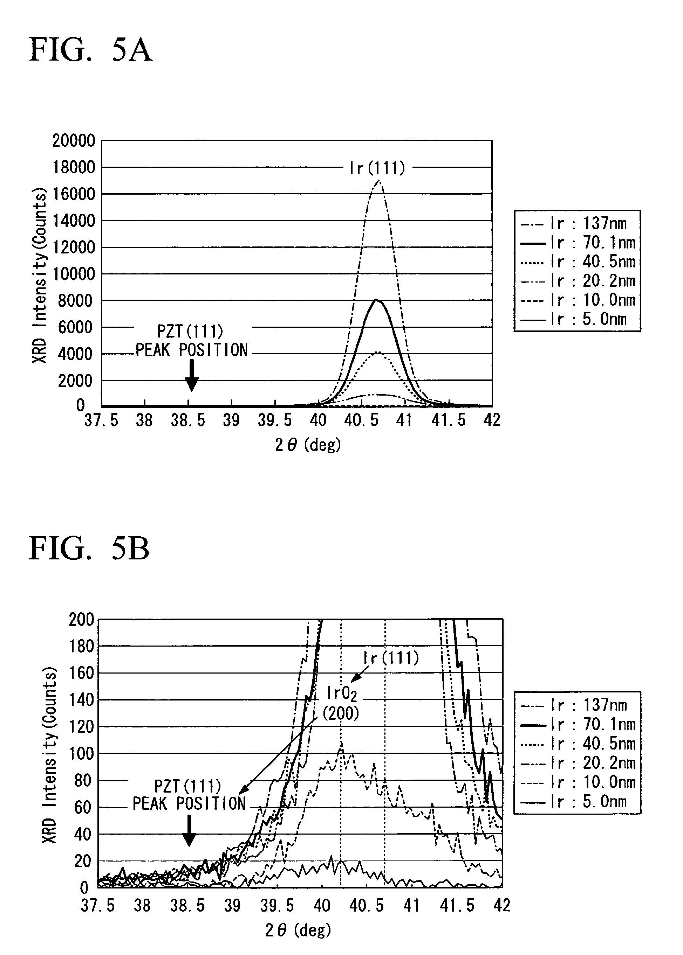

FIG. 5A is a graph showing the X-ray diffraction (XRD) intensities when the surfaces of lower electrode films having different thicknesses were oxidized. Here, oxygen gas was made to flow for 1800 seconds over the surfaces of lower electrode films having different thicknesses so as to create oxide films having a thickness of approximately 10 nm. In FIG. 5A, it can be seen that, as was to be expected, the XRD intensity of the Ir (111) decreased as the film thickness of the lower electrode film consisting of Ir (111) decreased.

FIG. 5B is an enlarged view of a portion of the vertical axis in FIG. 5A up to 200 (counts). When the film thickness of the lower electrode film is 20.2 nm or more, the XRD intensity peak exists in the vicinity of 2θ = 40.7 deg, which corresponds to Ir (111). In contrast to this, when the film thickness of the lower electrode film is 10 nm or less, the XRD intensity peak moves to the vicinity of 2θ = 40.2 deg, which corresponds to IrO₂ (200). The reason for this is thought to be that, in a lower electrode film having a thickness of 10 nm or less, the majority thereof is oxidized and IrO₂ (200) is created.

PZT (111), however, has an XRD intensity peak in the vicinity of 2θ = 38.5 deg. Namely, the interplanar spacing of the IrO₂ (200) which forms the oxide film is closer to the interplanar spacing of the PZT (111) than the Ir (111) which forms the lower electrode film. Because of this, it is difficult for the PZT (111) to grow on the surface of the Ir (111), and it is easy for the PZT (111) to grow on the surface of the IrO₂ (200). Accordingly, as is described above, it is though that, by forming an oxide film on the surface of the lower electrode film, the orientation intensity of the PZT (111) can be increased.

FIG. 4B is an enlarged view of a portion A shown in FIG. 4A. It can be seen that the XRD intensity of the PZT (111) increased as the oxygen gas flow time increased. However, there was no increase in the XRD intensity of the PZT (111) when the flow time was increased from 1800 seconds (when the thickness of the oxide film was 10 nm) to 3600 seconds. It is thought that this is because there is no increase in the growth facility of the PZT (111) when the thickness of the oxide film is increased to 10 nm or more. From this result, it was ascertained that the thickness of the oxide film is sufficient if formed to 10 nm. Accordingly, it is possible to reduce manufacturing costs while maintaining the maximum orientation intensity for the PZT (111).

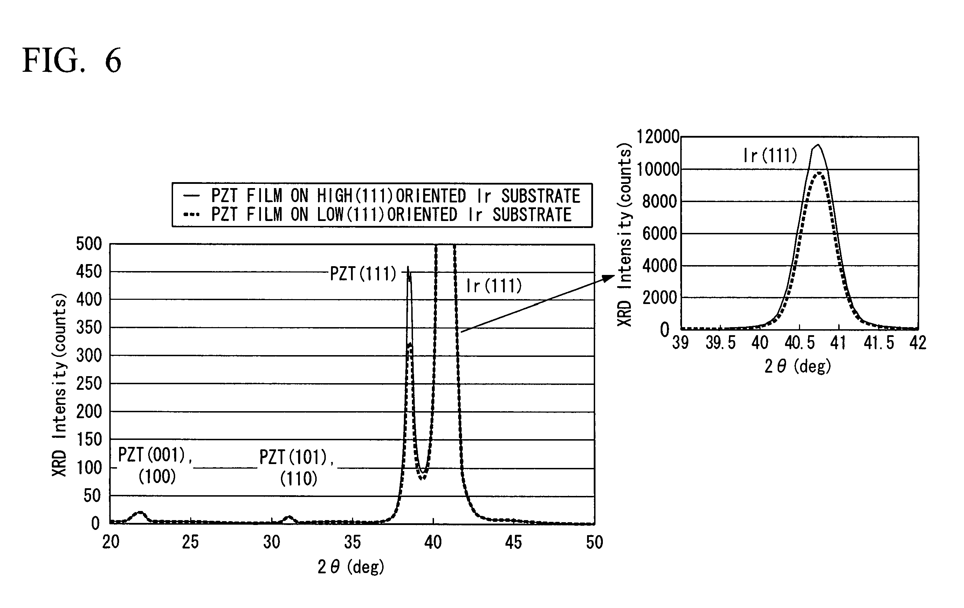

Next, a relationship between the orientation intensity of the Ir (111) forming the lower electrode film and the orientation intensity of the PZT (111) forming the ferroelectric film will be considered with reference to FIG. 6.
As is shown in FIG. 6, the greater the orientation intensity of the Ir (111) forming the lower electrode film, the greater the orientation intensity of the PZT (111). It is thought that this is because the greater the orientation intensity of the Ir (111), the greater the quantity of IrO₂ (200) which is created by oxidation and the easier it is for PZT (111) to grow.

As has been described above in detail, the film forming method of the present embodiment is a method of laminating a layer of ferroelectric film having PZT (111) as its principal component on a lower electrode film having Ir (111) as its principal component, the method including the steps of: forming an oxide film which has IrO₂ (200) as its principal component whose interplanar spacing is closer to PZT (111) than Ir (111); and forming the ferroelectric film by an MOCVD method on a surface of the oxide film.
According to the structure, it is easy for the PZT (111) to grow due to it being assisted by the IrO₂ (200) formed on the surface of the lower electrode film, and it is possible to increase the orientation intensity of the PZT (111).

It is desirable for the oxidation of the surface of the lower electrode film to be performed using an oxidizing gas supplied using an MOVCD process. Consequently, it is not necessary to provide a separate oxidizing gas supply device in order to oxidize the lower electrode film, and it is therefore possible to reduce equipment costs.

### (Second embodiment)

Next, a second embodiment will be described. Note that any detailed description of component elements that are the same as those in the first embodiment is omitted.
In the above described first embodiment, the oxide film 13 is formed by oxidizing the surface of the lower electrode film 12 shown in FIG. 1B, however, in the second embodiment a new oxide film 13 is laminated onto the surface of the lower electrode film 12. It is desirable for the constituent material of the oxide film 13 to be the same IrO₂ (200) as is used in the first embodiment. Moreover, the constituent material of the oxide film 13 may also be a crystal-oriented oxide electrode film. For example, SrRuO₃ and LaNiO₃ and the like may be employed for the oxide electrode film.

In order to form these oxide films 13, firstly, a non-crystalline film of the respective constituent materials is formed on the surface of the lower electrode film 12 by performing a spattering process at room temperature. Next, the non-crystalline film is heated using an RTA apparatus or the like so as to form a crystal-oriented oxide film 13. Note that it is also possible to form a crystal-oriented oxide film 13 directly by performing a spattering method in a high-temperature atmosphere.

In the second embodiment as well, in the same way as in the first embodiment, since an oxide film made up of IrO2 (200) and an oxide electrode film and the like is formed on the surface of a lower electrode, it is easy for the PZT (111) to grow with assistance from the oxide film, and thereby it is possible to increase the orientation intensity of the PZT (111) in a ferroelectric film.

Note that it is also possible to use crystal-oriented PZT (111) as the constituent material of the oxide film 13. It is desirable for an oxide film consisting of the PZT (111) to be formed using a process other than the MOCVD method. Specifically, it is possible for the oxide film to be formed using the same process as that used for the above described oxide film 13. In this case as well, since it is easy for the PZT (111) to be grown in the MOCVD method with assistance from the PZT (111) which forms the oxide film, it is possible to increase the orientation intensity of the PZT (111) in a ferroelectric film.

Note that the technological range of the present invention is not limited to the above described embodiments, but various modifications may be included in the above described embodiment insofar as they do not depart from the spirit or scope of the present invention. Namely, the specific materials and structure and the like described in the embodiment simply provide an example thereof, and various suitable modifications may be made thereto.

For example, as the organometal which is used for the PZT raw material, in addition to the above described materials it is also possible to use any one of or any combination of Zr (dhd)₄ ((tetrax (2,2,6,6) tetramethyl (3,5) heptanedionate) zirconium), Zr (MMP)₄ ((tetrax (1) methoxy (2) methyl (2) propoxy) zirconium), Ti (MMP)₄ ((tetrax (1) methoxy (2) methyl (2) propoxy) titanium), Zr (iPrO)₂ (thd)₂ ((bis isopropoxide) (bis (2,2,6,6) tetramethyl (3,5) heptanedionate) zirconium), Zr (iPrO) (thd)₃ ((isopropoxide) (tris (2,2,6,6) tetramethyl (3,5) heptanedionate) zirconium), Zr (thd) (dmhd)₃, Zr (thd)₂ (dmhd)₂, and Zr (thd)₃ (dmhd).
As the solvent, in addition to THF (tetrahydrofuran), it is also possible to use any one of or any combination of hexane, cyclohexane, ethylcyclohexane, methylcyclohexane, octane, and butyl acetate.

### INDUSTRIAL APPLICABILITY

It is possible to provide a film forming method and a film forming apparatus which make it possible to increase the orientation intensity of PZT (111).

## Claims

1. A film forming method in which a crystalline film having PZT (111) as a principal component thereof is laminated on a foundation film having a (111) oriented noble metal as a principal component thereof, the method comprising the steps of:
forming an oxide film whose interplanar spacing is closer to the PZT (111) than to the noble metal, on a surface of the foundation film; and
forming the crystalline film on the surface of the foundation film by an MOCVD method.

2. The film forming method according to claim 1, wherein, in the step of forming the oxide film, the oxide film of the noble metal which has a (200) orientation is formed by oxidizing the surface of the foundation film.

3. The film forming method according to claim 2, wherein the surface of the foundation film is oxidized using oxidizing gas which is supplied for the MOCVD method.

4. The film forming method according to claim 3, wherein the oxidizing gas is any one or any mixture of oxygen gas, dinitrogen monoxide gas, and ozone gas.

5. The film forming method according to claim 1, wherein, in the step of forming the oxide film, the oxide film is formed by being laminated onto the surface of the foundation film.

6. The film forming method according to claim 5, wherein the oxide film has IrO₂ (200) as a principal component thereof.

7. The film forming method according to claim 5, wherein the oxide film has PZT (111) as a principal component thereof.

8. The film forming method according to claim 5, wherein the oxide film has a crystal-oriented oxide electrode film as a principal component thereof.

9. The film forming method according to claim 8, wherein the oxide electrode film has either SrRuO₃ or LaNiO₃ as a principal component thereof.

10. The film forming method according to any one of claims 1 through 9, wherein the oxide electrode film is formed so as to have a thickness of 3 nm or more.

11. The film forming method according to any one of claims 1 through 9, wherein the oxide electrode film is formed so as to have a thickness of 10 nm or more.

12. A film forming apparatus which forms a crystalline film having PZT (111) as a principal component thereof on a substrate on which a foundation film having a (111) oriented noble metal as a principal component thereof has been formed, the apparatus comprising:
an oxidation chamber in which an oxide film of the noble metal is formed by oxidizing the surface of the foundation film;
a film formation chamber in which the crystalline film is formed on the surface of the oxide film using an MOCVD method; and
a substrate transporting chamber through which the substrate is transported from the oxidation chamber to the film formation chamber.

13. The film forming apparatus according to claim 12, wherein the oxidizing gas which is supplied for the MOCVD process in the film formation chamber is also supplied for the oxidation process performed in the oxidation chamber.
